# EUROPEAN PATENT APPLICATION

(11) **EP 4 550 404 A1**
(43) Date of publication of application: **07.05.2025**
(21) Application number: 23830791.2
(22) Date of filing: 14.04.2023
(51) Int. Cl.: H01L 23/36, C23C 16/27

(54) **MEMBER WITH HEAT SPREADER STRUCTURE AND METHOD FOR PRODUCING SAME**

(30) Priority: 01.07.2022 JP 2022107311
(71) Applicant: Shin-Etsu Handotai Co., Ltd., Tokyo 100-0004 (JP)
(72) Inventor: OHTSUKI, Tsuyoshi, Nishishirakawa-gun, Fukushima 961-8061 (JP)
(74) Representative: Röthinger, Rainer
(86) International application number: PCT/JP2023/015217
(87) International publication number: WO 2024/004337

(57) **Abstract**

The present invention is a member 34 having a heat spreader structure including a substrate member 31 in which an integrated circuit portion 10 is formed, and a heat spreader structure portion 9 formed on the integrated circuit portion 10, in which the integrated circuit portion 10 forms a recessed and protruding shape, the heat spreader structure portion 9 is formed by either a diamond layer 6 with a protruding and recessed shape that fits the recessed and protruding shape of the integrated circuit portion 10 or by a silicon substrate 8 having a diamond layer 6 formed thereon where the silicon substrate 8 has a protruding and recessed shape that fits the recessed and protruding shape of the integrated circuit portion 10, and the protruding and recessed shape of the heat spreader structure portion 9 is fitted to the recessed and protruding shape of the integrated circuit portion 10 to bond the heat spreader structure portion 9 to the substrate member 31. This provides a more efficient heat dissipation structure.

## Description

### TECHNICAL FIELD

The present invention relates to a member having a heat spreader structure and a method for producing the same. This provides a more efficient structure and means, particularly when using diamond having a high thermal conductivity as a heat dissipation material for an increasingly high-performance semiconductor device, regarding a semiconductor substrate and semiconductor equipment.

### BACKGROUND ART

With the advent of the full-fledged IoT era, the capacity of data centers (processing capability, data storage capability) has been expanding due to the active use of cloud computing, and the performance thereof has been enhanced. With higher performance, problems of heat generation from devices are considered to be more important than ever before. In fact, as disclosed in Non Patent Document 1, the power consumption of a single device reaches as much as about 600 W, and accompanying thermal control is becoming important.

In Non Patent Document 1, Compute Tile and HBM (High Band pass Memory) are connected to a heat spreader (Integrated Heat Spreader) via an intermediate material (Thermal Interface Material).

On the other hand, with the advent of 5G, solid-state power amplifiers, which easily realizes to make them compact and lightweight, are being widely used as high-frequency amplifiers such as mobile communication base stations or satellite communication systems. Also as in the previous cases, the temperature in the device rises due to self-heating generated during amplification operation, causing problems in which device characteristics and reliability are degraded.

As a concrete solution, a typical method for controlling the temperature rise is to connect a metal having high thermal conductivity such as copper (heat spreader) to the device (heating element) and to cool by air-cooling with, e.g., fins made on this metal or by a coolant (such as water-cooling). According to Non Patent Document 2, when focusing on thermal conductivity (unit: W/mK), diamond has a high thermal conductivity of 1000 to 2000 relative to that of copper being 386 to 402, indicating that the diamond is highly effective as a heat dissipation material for the device.

In fact, the use as the heat dissipation material of a semiconductor device has been proposed, focusing on this high thermal conductivity. Patent Document 1 discloses a method for bonding diamond or diamond-containing material which has high heat conductivity to a back surface of the semiconductor device.

Moreover, Patent Document 2 discloses a method for growing diamonds or bonding diamonds in an integrated circuit package in which semiconductor devices are integrated.

Moreover, Patent Document 3 discloses a method for improving thermal conductivity by controlling carbon isotopes that compose diamonds, focusing on a thermal conduction mechanism thereof.

As described above, heat dissipation (heat spreader) using diamond has attracted much attention because of high thermal conductivity thereof. Although Patent Document 3 discloses a method for increasing thermal conductivity of the diamond to a limit, a practical problem is how to bring the diamond in contact with the semiconductor device.

Patent Document 2 discloses growing diamond on an integrated circuit or bonding another substrate on which the diamond is grown. However, diamond growth requires a temperature of 800°C or more and plasma regardless of single-crystal or polycrystal, and thus it is considered that growing the diamond on the semiconductor integrated circuit has many restrictions because of problems of device protection.

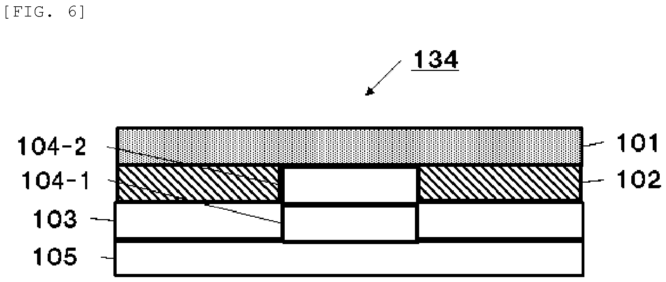

Based on FIG. 6, the heat spreader formed on the diamond-used integrated circuit is described.

FIG. 6 is an explanatory view of a structure including a typical heat sink.

As shown in FIG. 6, structure 134, which includes the typical heat sink, is formed so that a heat spreader (heat sink) metal 101 is formed on an integrated circuit support substrate 105 such as a laminate or PCB having a core (Core) 103 such as CPUs and Cash / HBM 104-1 and 104-2 thereon, with an intermediate material (dummy silicon) 102 interposed.

In this way, a mainstream of current integrated circuits has a structure where the core such as CPU, and memory such as Cashe or HBM are stacked on silicon or other substrates. Consequently, heights vary depending on the devices (such as CPU or memory), leading to differences in the heights when integrated. Typically, as shown in FIG. 6, in order to eliminate these steps, a dummy silicon or other materials are stacked and a metal such as copper is then bonded as a heat spreader, or diamond is bonded thereon as disclosed in Patent Document 2.

### CITATION LIST

### PATENT LITERATURE

Patent Document 1: JP 2004-158726 A
Patent Document 2: JP 2005-500668 A
Patent Document 3: JP 2021-119602 A

### NON PATENT LITERATURE

Non Patent Document 1: ISSCC 2022, Wilfred Gomes, et.al., "2.1 Ponte Vecchio: A Multi-Tile 3D Stacked Processor for Exascale Computing
Non Patent Document 2: AIST/Network Database System for Thermophysical Property Data (https://tpds.db.aist.go.jp/opendata/metal_tc.html)

### SUMMARY OF INVENTION

### TECHNICAL PROBLEM

In high-performance CPU, GPU, and NPU used in a data center, which is moving toward high performance and high functionality and becoming high integration, a measure to meet heat dissipation is crucial to prevent malfunction and reliability degradation of the device.

The problem to be solved by the present invention is a more efficient heat-dissipation structure and a method for producing a heat-dissipation structure capable of being easily formed without damaging an integrated circuit.

The present invention has been made in view of solving the above-described problem and provides a more efficient structure and means when using diamond, which has a high thermal conductivity as a heat-dissipation material for a semiconductor device that is continually advancing performance.

### SOLUTION TO PROBLEM

The present invention is to achieve an object described above and provides a member having a heat spreader structure comprising:
a substrate member in which an integrated circuit portion is formed; and
a heat spreader structure portion formed on the integrated circuit portion, wherein
the integrated circuit portion forms a recessed and protruding shape,
the heat spreader structure portion is formed by either a diamond layer with a protruding and recessed shape that fits the recessed and protruding shape of the integrated circuit portion or by a silicon substrate having a diamond layer formed thereon where the silicon substrate has a protruding and recessed shape that fits the recessed and protruding shape of the integrated circuit portion, and
the protruding and recessed shape of the heat spreader structure portion is fitted to the recessed and protruding shape of the integrated circuit portion to bond the heat spreader structure portion to the substrate member.

According to such a member having a heat spreader structure, a device having higher heat dissipation efficiency can be produced. More specifically, when stacking the diamond for heat dissipation (heat spreader) on the integrated circuit, the diamond that is stacked on another substrate is shaped in line with the recess and protrusion of the integrated circuit in advance, then the diamond and the integrated circuit are bonded.

The use of the diamond can be expected to improve heat dissipation characteristics by utilizing the high thermal conductivity of the diamond. In addition, the diamond grown on a silicon substrate is used to be bonded after removing the silicon substrate or partially removing thereof. By using the silicon substrate that is easy to process as a material in this way, it is possible to maintain the heat dissipation characteristics regardless of the recess and protrusion on the integrated circuit.

In this case, the member having a heat spreader structure described above can be provided, wherein
the heat spreader structure portion is a wafer, the substrate member is a wafer having the integrated circuit portion, and the wafers are bonded to each other.

When bonding Wafer-to-Wafer, it is possible to efficiently perform bonding by processing silicon (thickness and shape in XY directions) in line with the integrated circuit produced on the silicon substrate in advance and to easily form the high heat dissipation structure.

In this case, the member having a heat spreader structure described above can be provided, wherein
the heat spreader structure portion is a chip, the substrate member is a wafer having the integrated circuit portion, and the chip and the wafer are bonded.

As for a method for cutting the silicon substrate, on which the diamond is grown, to the size of the integrated circuit (diamond chips) and arranging as chip-to-Wafer, this piece of the diamond chip is provided in advance, and bonded to the recess portion of the integrated circuit. Then, the silicon substrate having the diamond grown thereon is bonded so as to cover the entire integrated circuit thereon, and finally, the silicon is removed. According to this production method, the high heat dissipation structure can be easily formed without damaging the integrated circuit.

In this case, the member having a heat spreader structure described above can be provided, wherein
the heat spreader structure portion is a chip, the substrate member is a chip, and the chips are bonded to each other.

As for a method for cutting the silicon substrate on which the diamond is grown to the size of the integrated circuit (diamond chips) and arranging as chip-to-chip, the diamond chip is provided with the shape in line with the integrated circuit by a method such as photolithography and bonded, the silicon substrate having the diamond grown thereon is then bonded so as to cover the entire integrated circuit thereon so as to cover the entire integrated circuit, and finally, the silicon is removed.

According to this production method, the high heat dissipation structure can be easily formed without damaging the integrated circuit.

In this case, the member having a heat spreader structure described above can be provided, wherein
the diamond layer is a CVD diamond layer.

By growing the diamond on the silicon substrate using the CVD method, the high heat dissipation structure can be easily formed.

The present invention is to achieve the above object and provides a method for producing a member having a heat spreader structure, the method comprising the steps of:
providing a substrate member with a recessed and protruding shape, in which an integrated circuit portion is formed;
providing a silicon substrate on which a diamond layer is formed;
forming a protruding and recessed shape that fits the recessed and protruding shape of the integrated circuit portion on the diamond layer, or forming a protruding and recessed shape that fits the recessed and protruding shape of the integrated circuit portion on the silicon substrate; and
fitting the protruding and recessed shape of the diamond layer to the recessed and protruding shape of the integrated circuit portion, then bonding therebetween, subsequently removing the silicon substrate on a surface to form a heat spreader structure portion composed solely of the diamond layer on the substrate member, or fitting the protruding and recessed shape of the silicon substrate to the recessed and protruding shape of the integrated circuit portion, then bonding therebetween, to form a heat spreader structure portion composed of the diamond layer and the silicon substrate.

A hetero substrate having diamond grown on the silicon substrate as this heat spreader is provided. Then either the protruding and recessed shape is formed to the diamond layer of this substrate that fits the recessed and protruding shape of the integrated circuit, or the silicon portion is first made into a thin film, followed by processing the silicon in line with the shape of the integrated circuit to this silicon portion.

When thinning the silicon portion, by adjusting the thickness to match the recess and protrusion of the integrated circuit, the heat spreader can be brought into close contact with each device of the integrated circuit, enabling effective heat conduction.

Moreover, a typical photolithography technique and subsequent etching technique can be used for the silicon processing described above without modification. Furthermore, when handling the thin-filmed wafer,
several methods are available, including a method for bonding a dummy substrate to the diamond side in advance, a method for leaving silicon thick only around a periphery of the silicon, and a method is not limited to those described here.

In this way, by processing the silicon in advance, it is possible to make the film thickness of the silicon layer between the diamond and the integrated circuit as thin as possible, enabling a formation of an efficient heat spreader.

According to this production method, the high heat dissipation structure can be easily formed without damaging the integrated circuit.

In this case, it is preferable that in the step of forming the protruding and recessed shape, at least a part of the silicon substrate is removed in line with the recessed and protruding shape of the integrated circuit portion to form the protruding and recessed shape.

According to this production method, the high heat dissipation structure can be easily formed without damaging the integrated circuit.

In this case, the method for producing a member having a heat spreader structure described above can be provided, further comprising a step of:
cutting the silicon substrate, on which the diamond layer is formed, into a piece to form a diamond chip, wherein
in the step of forming the heat spreader structure portion, the diamond chip is arranged so as to fit the protruding and recessed shape of the diamond layer or the silicon substrate to the recessed and protruding shape of the integrated circuit portion to bond the heat spreader structure portion to the substrate member.

According to this production method, the high heat dissipation structure can be easily formed without damaging the integrated circuit.

In this case, it is possible to further comprise, after the step of forming the heat spreader structure portion, the steps of:
bonding a silicon substrate on which another diamond layer is grown so as to cover all the diamond chips arranged on the substrate member with the silicon substrate on a front side; and
removing the silicon substrate.

According to this production method, the high heat dissipation structure can be easily formed without damaging the integrated circuit.

In this case, it is also possible to further comprise the steps of:
cutting the silicon substrate, on which the diamond layer is formed, into a piece to form a diamond chip,
cutting the substrate member, in which the integrated circuit portion is formed, into a piece to form an integrated-circuit chip, wherein
in the step of forming the heat spreader structure portion, after arranging the integrated-circuit chip, the diamond chip is bonded so as to fit the protruding and recessed shape to the recessed and protruding shape of the integrated circuit portion to form the heat spreader structure portion to the substrate member.

According to this production method, the high heat dissipation structure can be easily formed without damaging the integrated circuit.

In this case, the method for producing a member having a heat spreader structure described above can be provided, further comprising, after the step of forming the heat spreader structure portion, the steps of:
bonding a silicon substrate on which another diamond layer is grown so as to cover all the diamond chips arranged on the substrate members with the silicon substrate on a front side; and
removing the silicon substrate.

According to this production method, the high heat dissipation structure can be easily formed without damaging the integrated circuit.

### ADVANTAGEOUS EFFECTS OF INVENTION

As described above, according to the inventive member having a heat spreader structure, the heat dissipation characteristics can be improved by using the diamond to take advantage of the high thermal conductivity of the diamond.

In addition, according to the method for producing a member having a heat spreader structure, the diamond layer can be formed without damaging the integrated circuit, and the high heat dissipation structure can be easily formed. Moreover, the diamond material grown on the silicon substrate can be used, and a substrate having a large diameter can be used.

### BRIEF DESCRIPTION OF DRAWINGS

FIG. 1 is an explanatory view of a member having a heat spreader structure according to the present invention.
FIG. 2 is an explanatory view of a method for producing a member having a heat spreader structure according to the present invention.
FIG. 3 is an explanatory view of a method for producing a member having a heat spreader structure, as well as a view showing Wafer-to-Wafer bonding, according to the present invention.
FIG. 4 is an explanatory view of a method for producing a member having a heat spreader structure, as well as a view showing chip-to-Wafer bonding, according to the present invention.
FIG. 5 is an explanatory view of a method for producing a member having a heat spreader structure, as well as a view showing chip-to-chip bonding, according to the present invention.
FIG. 6 is an explanatory view of a structure including a typical heat sink.

### DESCRIPTION OF EMBODIMENTS

Hereinafter, embodiments of the present invention will be described. However, the present invention is not limited thereto.

As described above, a development of an integrated circuit having high thermal conductivity, and a simple method for producing the same without damaging the circuit, has been desired.

To solve the above problem, the present inventor has earnestly studied and found out that it is possible to achieve an integrated circuit having high thermal conductivity, and a simple method for producing the same without damaging the circuit by a heat spreader structure of the integrated circuit and the method for producing the same using diamond grown on a silicon substrate. This finding has led to the completion of the present invention.

### (First Embodiment)

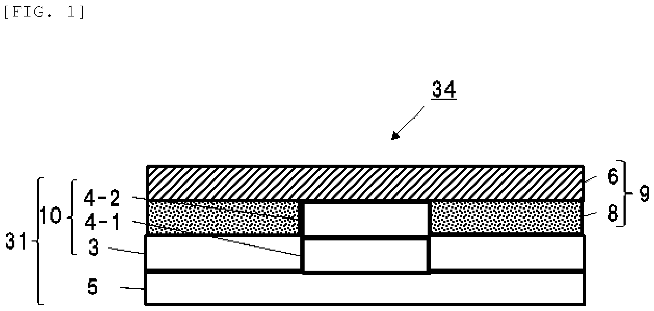

Hereinafter, a member having a heat spreader structure pertaining to the first embodiment of the present invention is described, referring to FIG. 1.

### (Member having Heat Spreader Structure)

FIG. 1 shows an explanatory view of the inventive member having a heat spreader structure.

As shown in FIG. 1, the inventive member 34 having a heat spreader structure includes a substrate member 31 in which an integrated circuit portion 10 is formed, and a heat spreader structure portion 9 formed on the integrated circuit portion 10.

### (Substrate Member)

The substrate member 31 is composed of a substrate 5 and the integrated circuit portion 10 which is formed on the substrate 5.

The substrate 5 is an integrated circuit support substrate such as a silicon substrate, a laminate, or PCB.

For example, the substrate member 31 is composed of the silicon substrate having 300 mm φ and the integrated circuit such as CPU produced on the silicon substrate.

### (Integrated Circuit Portion )

The integrated circuit portion 10 is composed of a core (Core) 3 such as a CPU, Cash / HBM 4-1, and 4-2.

The Cash / HBM 4-2 is formed by stacking on the Cash / HBM 4-1 and is structured to protrude to a portion corresponding only to the core 3. As a result, the integrated circuit portion 10 forms a recessed and protruding shape.

### (Heat Spreader Structure Portion)

The heat spreader structure portion 9 is formed by a silicon substrate 8 having a diamond layer 6 formed thereon where the silicon substrate 8 has a protruding and recessed shape that fits the recessed and protruding shape of the integrated circuit portion 10.

As is clear from FIG. 1, a through hole is formed in the silicon substrate 8, and the diamond layer 6 is in contact with Cash / HBM 4-2. That is, the silicon substrate 8 is processed in a way similar to fretwork.

In the member 34 having a heat spreader structure, the protruding and recessed shape of the heat spreader structure portion 9 fits the recessed and protruding shape of the integrated circuit portion 10, thereby bonding the heat spreader structure portion 9 to the substrate member 31.

### (Diamond Layer)

As for the diamond layer 6, although various synthesis methods have been known, for applying a semiconductor substrate, CVD (Chemical Vapor Deposition) methods such as microwave plasma or hot filament are used. Among these, it is considered that the hot filament method is preferable for applicability to a large-diameter substrate.

The hot filament method is a method in which a substrate is placed into a reaction furnace under reduced pressure, then applying an electric current to tungsten or titanium filament installed on the substrate to generate a high temperature in a state where methane and hydrogen are introduced as gases, thereby growing diamond by decomposing and activating the gases.

### (Method for Producing Member having Heat Spreader Structure)

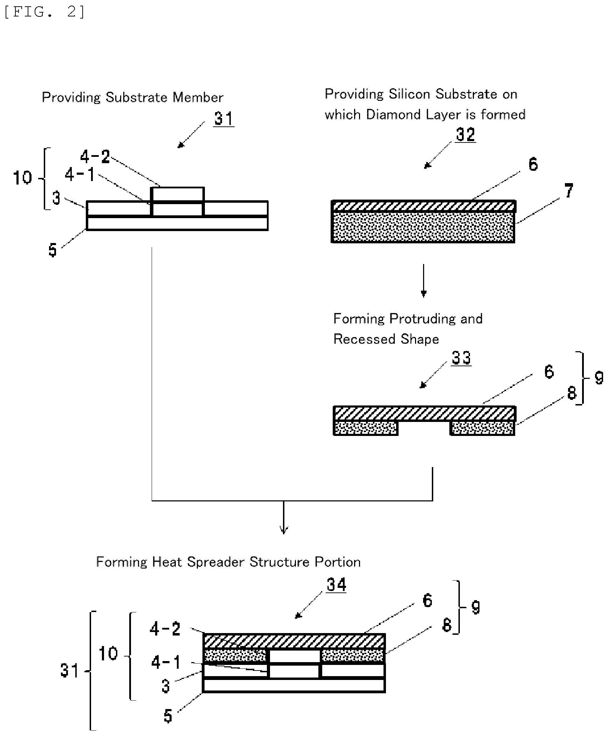

Next, a method for producing a member having a heat spreader structure pertaining to the first embodiment of the present invention is described, referring to FIG. 2.

FIG. 2 shows an explanatory view of the method for producing a member having a heat spreader structure of the present invention.

As shown in FIG. 2, the inventive method for producing a member having a heat spreader structure includes the steps of providing a substrate member, providing a silicon substrate on which a diamond layer is formed, forming a protruding and recessed shape, and forming a heat spreader structure portion.

### (Providing Substrate Member)

This step involves providing a substrate member 31, having a recessed and protruding shape, in which an integrated circuit portion 10 is formed.

For example, the substrate member can be provided by forming the integrated circuit on the silicon substrate using conventional methods such as a photolithography method.

### (Providing Silicon Substrate on which Diamond Layer is Formed)

This step involves providing a silicon substrate 7 on which a diamond layer 6 is formed.

A diamond hetero substrate grown on the silicon substrate by a CVD method is provided.

The silicon substrate 7, on which the diamond layer 6 is formed, is a diamond-layer-formed silicon substrate 32.

### (Forming Protruding and Recessed Shape)

This step involves forming a protruding and recessed shape that fits the recessed and protruding shape of the integrated circuit portion 10 on the silicon substrate 7. The silicon substrate 7 is then made into a processed silicon substrate 8.

For example, in the step of forming the protruding and recessed shape, at least a part of the silicon substrate 7 is removed in line with the recessed and protruding shape of the integrated circuit portion 10 to form the protruding and recessed shape.

First, the silicon substrate 7 is made into a thin film (determined based on a step of the integrated circuit), followed by removing the silicon in line with the shape of the integrated circuit by the photolithography method.

The diamond layer 6 is formed, and the processed silicon substrate 8 is then made into a protruding and recessed shape formed substrate 33.

### (Forming Heat Spreader Structure Portion)

This step involves forming the heat spreader structure portion 9 composed of the diamond layer 6 and the silicon substrate 8 on the substrate member 31 by fitting and bonding the protruding and recessed shape of the silicon substrate 8 to the recessed and protruding shape of the integrated circuit portion 10.

In this case, for example, the silicon substrate 8 may be activated on a surface thereof by plasma, or bonding may be performed by using adhesive or the like.

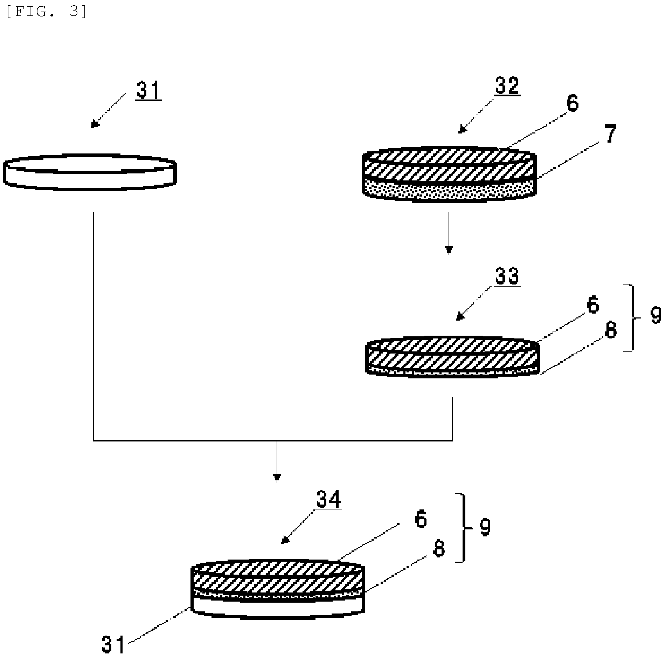

FIG. 3 is an explanatory view of the inventive method for producing a member having a heat spreader structure, as well as a view showing Wafer-to-Wafer bonding.

As shown in FIG. 3, the heat spreader structure portion 9 is a wafer, the substrate member 31 is a wafer having the integrated circuit portion, and the wafers above are bonded together.

### (Second Embodiment)

Hereinafter, a member having a heat spreader structure pertaining to the second embodiment of the present invention is described.

The inventive member having a heat spreader structure pertaining to the second embodiment is configured in the same way as in the first embodiment except that a heat spreader structure portion 9 is formed by a diamond layer 6 with a protruding and recessed shape that fits the recessed and protruding shape of the integrated circuit portion 10.

In addition, a method for producing a member having a heat spreader structure pertaining to the second embodiment of the present invention is configured in the same way as in the first embodiment except that the step of forming a protruding and recessed shape involves forming a protruding and recessed shape that fits the recessed and protruding shape of the integrated circuit portion on the diamond layer; and fitting the protruding and recessed shape of the diamond layer to the recessed and protruding shape of the integrated circuit portion, then bonding therebetween, subsequently removing the silicon substrate on a surface to form a heat spreader structure portion composed solely of the diamond layer on the substrate member.

Note that the silicon substrate can be removed by etching, grinding, or polishing.

### (Third Embodiment)

Hereinafter, a method for producing a member having a heat spreader structure pertaining to the third embodiment of the present invention is described.

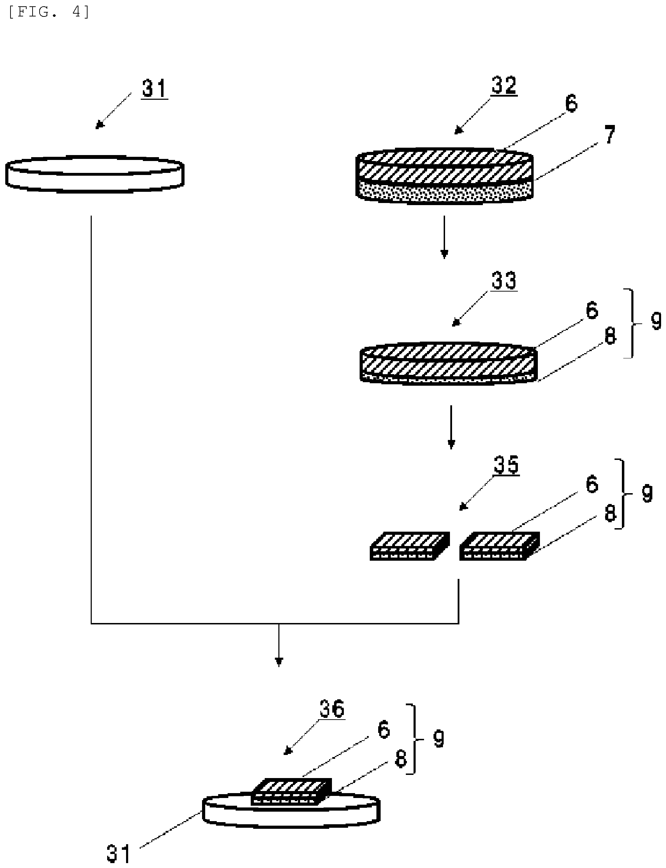

FIG. 4 is an explanatory view of the method for producing a member having a heat spreader structure pertaining to the third embodiment of the present invention, as well as a view showing chip-to-Wafer bonding.

As shown in FIG. 4, a heat spreader structure portion 9 is a chip, a substrate member 31 is a wafer having an integrated circuit portion, and the chip and the wafer above are bonded.

The method for producing a member having a heat spreader structure pertaining to the third embodiment according to the present invention is configured in the same way as in the first embodiment except that chip-to-Wafer bonding is employed.

The first embodiment is an example of wafer-to-wafer, but chip-to-wafer is also possible. This method includes the following. The integrated circuits are wafer-shaped. Unlike the first embodiment, diamond to be bonded thereto is provided in advance as dies (chips) for use as a heatsink, the dies are then arranged on the integrated circuits, and bonded together (the bonding method may be surface activation of the diamond die or may use an adhesive). Even in this case, efficient heat dissipation is enabled by making a silicon substrate with diamond grown thereon into a thin film in advance.

In this case, it is possible to optionally select which of the diamond surface or silicon surface is bonded to the integrated circuit.

The method for producing a member having a heat spreader structure pertaining to the third embodiment according to the present invention further includes a step of cutting the silicon substrate 8, on which the diamond layer 6 is formed, into pieces to form diamond chips 35.

In the step of forming the heat spreader structure portions 9 on the substrate member 31 by fitting and bonding a protruding and recessed shape each of the diamond layers 6 or the silicon substrates 8 to a recessed and protruding shape each of the integrated circuit portions 10; the diamond chips 35 are arranged so as to fit the protruding and recessed shape each of the diamond layers 6 or the silicon substrates 8 to the recessed and protruding shape each of the integrated circuit portions 10 to bond the heat spreader structure portions 9 to the substrate member 31.

Thereby, a chip-to-Wafer bonded substrate 36 is produced.

Furthermore, after the step of forming the heat spreader structure portions 9 on the substrate member 31 by fitting and bonding the protruding and recessed shape each of the diamond layers 6 or the silicon substrates 8 to the recessed and protruding shape each of the integrated circuit portions 10, it is preferable to include the steps of bonding a silicon substrate on which another diamond layer is grown so as to cover all the diamond chips arranged on the substrate member with the silicon substrate on a front side and removing the silicon substrate.

In this way, the inventive method further includes that a large diamond substrate may be bonded thereon so as to cover the entire surface.

### (Fourth Embodiment)

Hereinafter, a method for producing a member having a heat spreader structure pertaining to the fourth embodiment of the present invention is described.

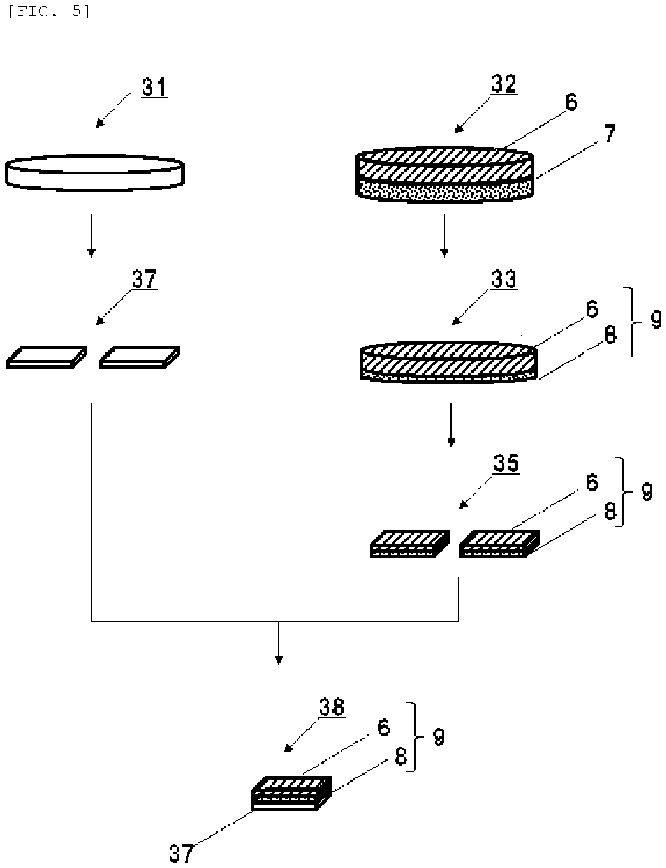

FIG. 5 is an explanatory view of the inventive method for producing a member having a heat spreader structure, as well as a view showing chip-to-chip bonding.

As shown in FIG. 5, a heat spreader structure portion 9 is a chip, a substrate member 31 is a chip, and the chips above are bonded together.

The method for producing a member having a heat spreader structure pertaining to the fourth embodiment according to the present invention is configured in the same way as in the first embodiment except that chip-to-chip bonding is employed.

The first embodiment is an example of wafer-to-wafer, and the third embodiment is an example of chip-to-wafer, but chip-to-chip is also possible.

This method involves providing integrated circuit chips and dies (chips) for use as a heatsink in advance and arranging the dies (chips) on the integrated circuit chips to bond together, respectively (a bonding method may be either surface activation of the diamond die or may be an adhesive). Even in this case, efficient heat dissipation is enabled by making a silicon substrate with diamond grown thereon, into a thin film in advance.

The method for producing a member having a heat spreader structure pertaining to the fourth embodiment according to the present invention further includes steps of cutting the silicon substrate 8, on which the diamond layer 6 is formed, into pieces to form the diamond chips 35, and cutting the substrate member, in which the integrated circuit portions are formed into pieces to form integrated-circuit chips 37.

In the step of forming the heat spreader structure portion 9 each on the substrate members by fitting and bonding the protruding and recessed shape each of the diamond layers 6 or the silicon substrates 8 to a recessed and protruding shape each of the integrated circuit portions, the diamond chips 35 are arranged so as to fit the protruding and recessed shape each of the diamond layers 6 or the silicon substrates 8 to the recessed and protruding shape each of the integrated circuit portions to bond the heat spreader structure portions 9 to the substrate members 31, respectively.

Thereby, a chip-to-chip bonded substrates 38 are produced.

Further, after the step of forming the heat spreader structure portion 9 each on the substrate members 31 by fitting and bonding the protruding and recessed shape each of the diamond layers 6 or the silicon substrates 8 to the recessed and protruding shape each of the integrated circuit portions 10, it is preferable to include the steps of bonding a silicon substrate on which another diamond layer is grown so as to cover all the diamond chips arranged on the substrate members, respectively, with the silicon substrate on a front side and removing the silicon substrate.

### EXAMPLE

Hereinafter, the present invention will be specifically described with reference to Examples. However, the present invention is not limited thereto.

### (Example 1)

A diamond layer was formed on a silicon substrate having 300 mmφ by a thermal filament method.

The diamond had a microcrystalline state and a thickness of 0.05 mm.

Using such a silicon wafer, silicon on an opposite side of a diamond-formed surface was thinned by grinding. In this case, the silicon in the wafer peripheral portion was left at an original thickness to allow photolithography to be performed.

Protruding and recessed structures were formed by the photolithography.

Heat spreader structures were produced by bonding to a wafer on which integrated circuits had been made.

### (Example 2)

A diamond layer was formed on a silicon substrate having 300 mmφ by a thermal filament method.

The diamond had a microcrystalline state and a thickness of 0.05 mm.

Using such a silicon wafer to cut it into an appropriate size, silicon on an opposite side of a diamond-formed surface was thinned by grinding and made into chips and photolithography was performed to form protrusion and recess structures.

Heat spreader structures were produced by bonding to a wafer on which an integrated circuit had been made.

Through performance evaluation tests of the integrated circuit, it was found that producing a heat spreader structure did not damage an integrated circuit, and heat dissipation efficiency was high due to the heat spreader structure.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A member having a heat spreader structure comprising:
a substrate member in which an integrated circuit portion is formed; and
a heat spreader structure portion formed on the integrated circuit portion, wherein
the integrated circuit portion forms a recessed and protruding shape,
the heat spreader structure portion is formed by either a diamond layer with a protruding and recessed shape that fits the recessed and protruding shape of the integrated circuit portion or by a silicon substrate having a diamond layer formed thereon where the silicon substrate has a protruding and recessed shape that fits the recessed and protruding shape of the integrated circuit portion, and
the protruding and recessed shape of the heat spreader structure portion is fitted to the recessed and protruding shape of the integrated circuit portion to bond the heat spreader structure portion to the substrate member.

2. The member having a heat spreader structure according to claim 1, wherein
the heat spreader structure portion is a wafer, the substrate member is a wafer having the integrated circuit portion, and the wafers are bonded to each other.

3. The member having a heat spreader structure according to claim 1, wherein
the heat spreader structure portion is a chip, the substrate member is a wafer having the integrated circuit portion, and the chip and the wafer are bonded.

4. The member having a heat spreader structure according to claim 1, wherein
the heat spreader structure portion is a chip, the substrate member is a chip, and the chips are bonded to each other.

5. The member having a heat spreader structure according to any one of claims 1 to 4, wherein
the diamond layer is a CVD diamond layer.

6. A method for producing a member having a heat spreader structure, the method comprising the steps of:
providing a substrate member with a recessed and protruding shape, in which an integrated circuit portion is formed;
providing a silicon substrate on which a diamond layer is formed;
forming a protruding and recessed shape that fits the recessed and protruding shape of the integrated circuit portion on the diamond layer, or forming a protruding and recessed shape that fits the recessed and protruding shape of the integrated circuit portion on the silicon substrate; and
fitting the protruding and recessed shape of the diamond layer to the recessed and protruding shape of the integrated circuit portion, then bonding therebetween, subsequently removing the silicon substrate on a surface to form a heat spreader structure portion composed solely of the diamond layer on the substrate member, or fitting the protruding and recessed shape of the silicon substrate to the recessed and protruding shape of the integrated circuit portion, then bonding therebetween, to form a heat spreader structure portion composed of the diamond layer and the silicon substrate.

7. The method for producing a member having a heat spreader structure according to claim 6, wherein
in the step of forming the protruding and recessed shape, at least a part of the silicon substrate is removed in line with the recessed and protruding shape of the integrated circuit portion to form the protruding and recessed shape.

8. The method for producing a member having a heat spreader structure according to claim 6 or 7, further comprising a step of:
cutting the silicon substrate, on which the diamond layer is formed, into a piece to form a diamond chip, wherein
in the step of forming the heat spreader structure portion, the diamond chip is arranged so as to fit the protruding and recessed shape of the diamond layer or the silicon substrate to the recessed and protruding shape of the integrated circuit portion to bond the heat spreader structure portion to the substrate member.

9. The method for producing a member having a heat spreader structure according to claim 8, further comprising, after the step of forming the heat spreader structure portion, the steps of:
bonding a silicon substrate on which another diamond layer is grown so as to cover all the diamond chips arranged on the substrate member with the silicon substrate on a front side; and
removing the silicon substrate.

10. The method for producing a member having a heat spreader structure according to claim 6 or 7, further comprising the steps of:
cutting the silicon substrate, on which the diamond layer is formed, into a piece to form a diamond chip,
cutting the substrate member, in which the integrated circuit portion is formed, into a piece to form an integrated-circuit chip, wherein
in the step of forming the heat spreader structure portion, after arranging the integrated-circuit chip, the diamond chip is bonded so as to fit the protruding and recessed shape to the recessed and protruding shape of the integrated circuit portion to form the heat spreader structure portion to the substrate member.

11. The method for producing a member having a heat spreader structure according to claim 10, further comprising, after the step of forming the heat spreader structure portion, the steps of:
bonding a silicon substrate on which another diamond layer is grown so as to cover all the diamond chips arranged on the substrate members with the silicon substrate on a front side; and
removing the silicon substrate.
